Europäisches Patentamt

European Patent Office

Office européen des brevets

(19)

(11) Numéro de publication: **0 253 727 B1**

(12) **FASCICULE DE BREVET EUROPEEN**

(45) Date de publication de fascicule du brevet:
**16.10.91**

(51) Int. Cl.5: **G02F 1/133**, H01L 27/12,
H01L 29/16

(21) Numéro de dépôt: **87401646.2**

(22) Date de dépôt: **10.07.87**

(54) Ecran d'affichage à matrice active utilisant du carbure de silicium amorphe hydrogéné et procédé de fabrication de cet écran.

(30) Priorité: **16.07.86 FR 8610349**

(43) Date de publication de la demande:
**20.01.88 Bulletin 88/03**

(45) Mention de la délivrance du brevet:
**16.10.91 Bulletin 91/42**

(84) Etats contractants désignés:
**BE CH DE GB IT LI NL SE**

(56) Documents cités:
**EP-A- 0 103 523**
**EP-A- 0 182 484**

**PATENT ABSTRACTS OF JAPAN, vol. 9, no. 305 (E-363)[2028], 3 décembre 1985; & JP-A-60 142 566**

**EMIS DATAREVIEWS SERIES, no. 1, Properties of Amorphous silicon, 1985, Inspec. Londres, GB**

**PATENT ABSTRACTS OF JAPAN, vol. 10, no. 141 (E-406)[2198], 24 mai 1986; & JP-A-61 5579**

(73) Titulaire: **Morin, François**
**Le Carpont Lanmerin**
**F-22300 Lannion(FR)**

Titulaire: **Le Contellec, Michel**
**3 Hameau du Chêne**
**F-22300 Lannion(FR)**

Titulaire: **Richard, Joseph**
**33 Lotissement Keranroux Ploubezre**
**F-22300 Lannion(FR)**

(72) Inventeur: **Morin, François**
**Le Carpont Lanmerin**
**F-22300 Lannion(FR)**
Inventeur: **Le Contellec, Michel**
**3 Hameau du Chêne**
**F-22300 Lannion(FR)**
Inventeur: **Richard, Joseph**
**33 Lotissement Keranroux Ploubezre**
**F-22300 Lannion(FR)**

(74) Mandataire: **Mongrédien, André et al**
**c/o BREVATOME 25, rue de Ponthieu**
**F-75008 Paris(FR)**

## Description

La présente invention a pour objet un écran d'affichage à matrice active et un procédé de fabrication de cet écran. Elle trouve une application dans l'affichage d'informations à l'aide d'écrans à cristaux liquides.

Un écran d'affichage à matrice active comprend généralement deux plaques entre lesquelles est intercalé un matériau électro-optique comme un cristal liquide. Sur l'une des plaques on trouve une matrice de pavés conducteurs transparents, des transistors en couches minces, une famille de lignes conductrices d'adressage et une famille de colonnes conductrices d'adressage. Chaque transistor possède une grille reliée à une ligne, une source reliée à un pavé et un drain relié à une colonne. Sur l'autre plaque, on trouve une contre-électrode.

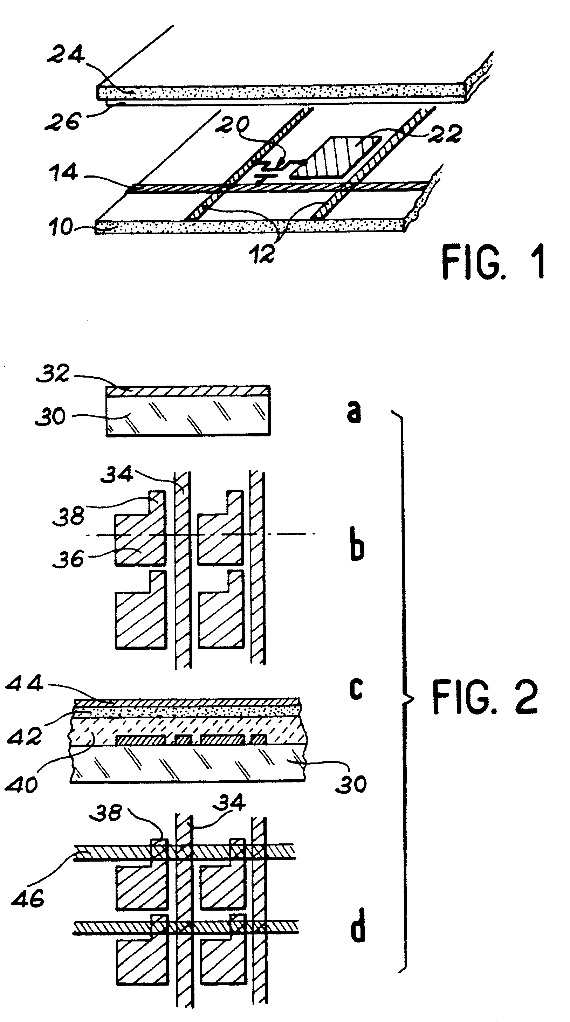

Une telle structure est représentée sur la figure 1. On y voit, de manière simplifiée, une plaque inférieure 10 portant des colonnes conductrices 12, des lignes conductrices 14, des transistors 20 et des pavés conducteurs 22, et une plaque supérieure 24 recouverte d'une contre-électrode 26.

Pour obtenir une telle structure, on peut mettre en oeuvre un procédé connu dont les principales étapes sont illustrées sur la figure 2. Ce procédé comprend les opérations suivantes :
- préparation d'un substrat de verre 30 par nettoyage physico-chimique,
- dépôt d'une couche 32 de matériau conducteur transparent, par exemple en oxyde d'étain et d'indium (ITO) (partie a),
- première photogravure, pour donner à la couche 32 la forme de colonnes 34 et de pavés 36 reliés à un segment 38 (partie b),
- dépôts d'une couche semiconductrice 40, d'une couche d'isolant 42 et d'une couche métallique 44 (partie c),
- seconde photogravure appliquée à l'empilement précédent pour définir des lignes 46 chevauchant les segments 38 et croisant les colonnes 34, ce qui définit des transistors à couches minces (partie d),
- passivation générale par dépôt d'une couche de $SiO_2$ (non représentée).

Un tel procédé, à deux niveaux de masquage, est décrit dans la demande de brevet français FR-A 2 533 072.

Si ce procédé "à deux niveaux" représente déjà une nette amélioration par rapport aux autres procédés qui comportent 4 à 6 niveaux de photolithographie, il présente cependant un inconvénient qui conduit à créer un point faible dans la structure obtenue. Il s'agit de la gravure de l'empilement semiconducteur 40,isolant 42,métal 44. Une surgravure du semiconducteur est presque inévitable et peut donner lieu à la formation de cavernes. Celles-ci favorisent la rétention d'impuretés, ce qui est à l'origine de dégradations.

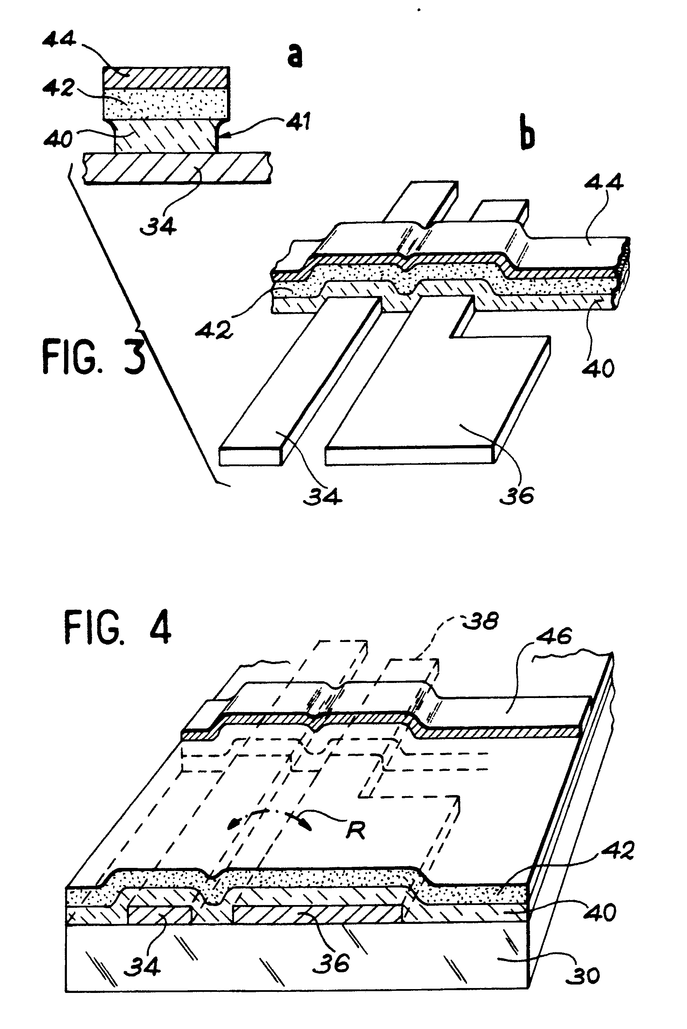

Cette surgravure apparaît avec la référence 41 sur la figure 3, partie a, qui montre une coupe selon une colonne 34. La partie b de cette même figure montre la structure en perspective.

Un autre inconvénient est que les lignes et les colonnes ne sont séparées que par un sandwich de 100 à 300 nm environ d'épaisseur : on conçoit que la tranche de ce sandwich soit le lieu privilégié de formation de courts-circuits lignes-colonnes, soit par la présence de particules conductrices venant ponter cette tranche, soit par la formation de chemins conducteurs résultant de claquages électrostatiques par exemple.

Ces inconvénients, s'ils existent, sont cependant peu fréquents puisque, sur des écrans de 80000 points (ce qui représente autant de croisements lignes-colonnes), on dénombre généralement moins de 5 courts-circuits, même avec une technologie artisanale. Cependant, il s'agit là tout de même d'un inconvénient inhérent au procédé antérieur dit "a deux niveaux" et doit être supprimé si l'on veut obtenir des écrans sans défauts.

La présente invention a justement pour but de remédier à cet inconvénient. A cette fin, elle préconise, lors de la seconde photogravure, de ne pas effectuer la gravure complète de l'empilement semiconducteur 40,isolant 42,conducteur 44, pour éviter l'apparition d'une tranche à nu, à l'origine de ces risques. Selon l'invention, on ne gravera en fait que le dépôt métallique destiné à former les lignes. Ce résultat est rendu possible par l'emploi de carbure de silicium amorphe hydrogéné (aSiC:H) comme semiconducteur, aux lieu et place du silicium amorphe classique employé jusqu'ici. Le choix du carbure de silicium amorphe hydrogéné se trouve être particulièrement judicieux à cause de sa transparence. En effet, la présence de carbone (en quantité limitée à quelques pourcents) suffit à augmenter la bande interdite du semiconducteur et à repousser l'absorption optique vers les ultraviolets. Ce matériau peut donc être quasiment transparent, surtout si on l'utilise en couche très mince (environ 50 nm). D'un point de vue strictement optique, on peut donc laisser le semiconducteur sur toute la surface de la matrice, sans que la transparence de l'écran s'en trouve notablement affectée.

Il y a lieu cependant de veiller à la résistance de fuite que l'on introduit alors entre un pavé et la colonne adjacente. Elle doit rester très élevée, de telle sorte que la constante de temps RC où R est cette résistance et C la capacité de la cellule à cristal liquide, excède largement 20 ms, qui est le temps d'adressage moyen.

Dans le tableau ci-dessous, on a reporté les valeurs de résistivité pour aSiH et aSiCH, ainsi que la photoconductivité de ces deux matériaux. Ces données permettent de conclure que, même sous éclairement, la résistance de fuite R est suffisamment grande pour avoir un effet négligeable.

|   | aSiH | aSiCH |
|---|---|---|
| E | $1,6$ | $2$ |
| R | $10^9$ | $10^{10}$ à $10^{12}$ |
| PC | $10^{-5}$ | $10^{-5}$ à $10^{-11}$ |

Dans ce tableau E désigne la largeur de la bande interdite en électron-volt, R la résistivité en Ohm.cm, et PC la photoconductivité en $Ohm^{-1}.cm^{-1}$ (cette dernière caractéristique dépendant évidemment de la concentration en carbone).

De façon précise la présente invention a donc pour objet un écran d'affichage à matrice active comme celui qui a été décrit plus haut, avec une première paroi portant un premier niveau constitué d'une matrice de pavés et d'une famille de colonnes d'adressage et un deuxième niveau comprenant une famille de lignes d'adressage, ces deux niveaux étant séparés par un empilement d'une couche de semiconducteur et d'une couche d'isolant, cet écran étant caractérisé par le fait que, dans l'empilement séparant les deux niveaux, le semiconducteur est en carbure de silicium amorphe hydrogéné, la couche de ce semiconducteur ainsi que la couche d'isolant, recouvrant la totalité de la première paroi.

Dans une première variante, le premier niveau comprenant les colonnes d'adressage et les pavés est au contact avec la première paroi, le deuxième niveau avec les lignes d'adressage étant situé au-dessus de l'empilement carbure de silicium hydrogéné-isolant.

Dans une seconde variante, la disposition est inversée : le second niveau comprenant les lignes d'adressage est au contact avec la première paroi et c'est le premier niveau comprenant les colonnes d'adressage et les pavés qui est situé au-dessus de l'empilement isolant-carbure de silicium hydrogéné.

En pratique, la concentration en carbone, dans le carbure de silicium amorphe hydrogéné, est comprise entre 2 et 10%. L'épaisseur de la couche en carbure de silicium amorphe hydrogéné est comprise entre 20 et 100 nm.

La présente invention a également pour objet un procédé de fabrication d'un tel écran. Ce procédé comprend deux variantes correspondant aux deux variantes de réalisation de l'écran, l'une directe, l'autre inverse.

De toute façon, les caractéristiques de l'invention apparaîtront mieux à la lumière de la description qui suit, d'exemples de réalisation donnés à titre explicatif et nullement limitatif. Cette description se réfère à des dessins annexés, sur lesquels :
  - la figure 1, déjà décrite, représente une cellule d'affichage à matrice active,
  - la figure 2, également décrite, montre quelques étapes d'un procédé de fabrication à deux niveaux selon l'art antérieur,
  - la figure 3, déjà décrite montre un détail d'une structure de l'art antérieur,
  - la figure 4 montre, en perspective, un détail d'un écran selon l'invention,
  - la figure 5 (a, b) montre une coupe le long d'une ligne (a) d'un écran d'affichage selon l'invention, et une coupe selon une colonne (b),
  - la figure 6 montre schématiquement une coupe d'un transistor en couches minces,
  - la figure 7 montre des caractéristiques courant-tension pour ce transistor,
  - la figure 8 illustre un second mode de réalisation de l'invention dans lequel l'ordre des photogravures est inversé, ce qui conduit à des transistors "à l'envers",
  - la figure 9 montre quelques étapes d'un procédé de réalisation dans cette seconde variante.

Sur la figure 4 est représenté, un détail d'un écran d'affichage selon l'invention dans une vue en perspective semblable à celle de la figure 3. On voit, qu'à la différence de l'art antérieur, l'empilement semiconducteur 40,isolant 42 recouvre la totalité de la paroi 30, et en particulier les pavés 36 et les colonnes 34. Les colonnes et les pavés ne sont donc plus mis à nu et les risques de surgravure de la couche semiconductrice disparaissent. Ceci est rendu possible par l'utilisation comme semiconducteur 40 de carbure de silicium amorphe hydrogéné.

On observera cependant que la présence de la couche de carbure de silicium amorphe hydrogéné sur toute la surface de la paroi, entraîne l'apparition d'une résistance de fuite R symbolisée par la double flèche R entre un pavé et la colonne adjacente. C'est cette résistance qu'il faudra rendre élevée pour avoir une constante de temps RC très supérieure au cycle d'adressage qui est de l'ordre de 20 ms.

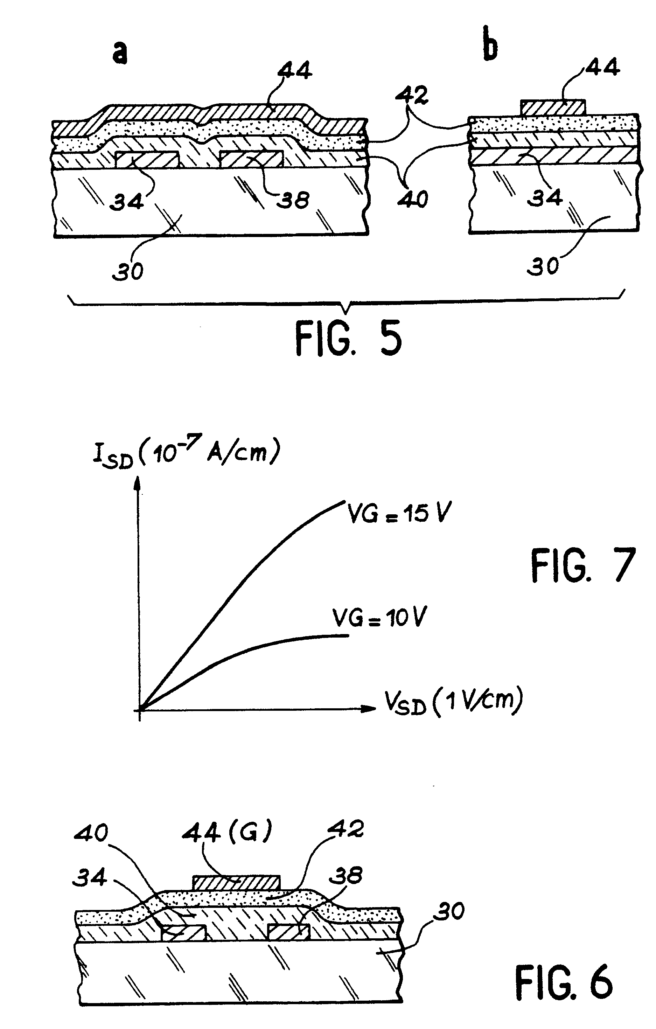

La figure 5 montre deux coupes de la paroi inférieure d'un écran d'affichage selon l'invention. La coupe a est effectuée le long d'une ligne d'adressage 44. La coupe b est effectuée le long d'une colonne 34. Par comparaison avec la partie a de la figure 3, on aperçoit bien l'originalité de la structure de l'invention avec ses couches isolantes 42 en carbure de silicium amorphe hydrogéné 40, qui s'étendent sur toute la surface de la paroi.

En ce qui concerne le procédé de réalisation d'un tel écran, les opérations s'effectuent dans l'ordre classique tel qu'il apparaît dans le document FR-2 533 072 déjà cité. On peut se reporter à la figure 2 de la présente demande qui rappelle les différentes étapes de ce procédé. On développe successivement deux niveaux d'opérations.

Niveau 1 :

- dépôt d'une couche conductrice transparente d'oxyde d'étain et d'indium (ITO),
- photogravure de la couche d'ITO et délimitation des colonnes et des pavés qui forment respectivement les sources et drains des futurs transistors,
- en variante, on peut déposer une couche de carbure de silicium amorphe dopé sur l'ITO avant gravure, pour améliorer les contacts avec la source et le drain des transistors ;

Niveau 2 :

- dépôt de aSiC:H. Cette opération se fait par PECVD (Plasma Enhanced Chemical Vapor Deposition). Le substrat de verre est introduit dans un réacteur et porté à une température voisine de 250°C ; le gaz de travail (à pression réduite) peut être du silane dilué avec une faible quantité de méthane ou d'éhylène ; un plasma radiofréquence de très faible puissance permet de décomposer ces gaz et de former un dépôt de aSiC:H ;
- dépôt d'isolant, par exemple $Si_3N_4$ par la même technique ; le gaz de travail est cette fois du silane dilué et de l'ammoniaque ;
- dépôt du métal de grille par exemple d'aluminium ; l'aluminium est déposé sous vide par évaporation au canon à électrons ; en variante, on peut procéder par "pelage" en déposant d'abord un photorésist puis en évaporant l'aluminium et enfin en éliminant le photorésist et le métal en excès,
- gravure du niveau 2 ; on grave le dépôt d'aluminium à l'aide d'un deuxième masque de façon à former des lignes d'adressage.

La figure 6 montre une coupe du transistor en couches minces (TCM) obtenu.

Deux caractéristiques courant source-drain ($I_{SD}$) en fonction de la tension source-drain ($V_{SD}$) sont données sur la figure 7 pour deux valeurs de la tension de grille VG (10V et 15V).

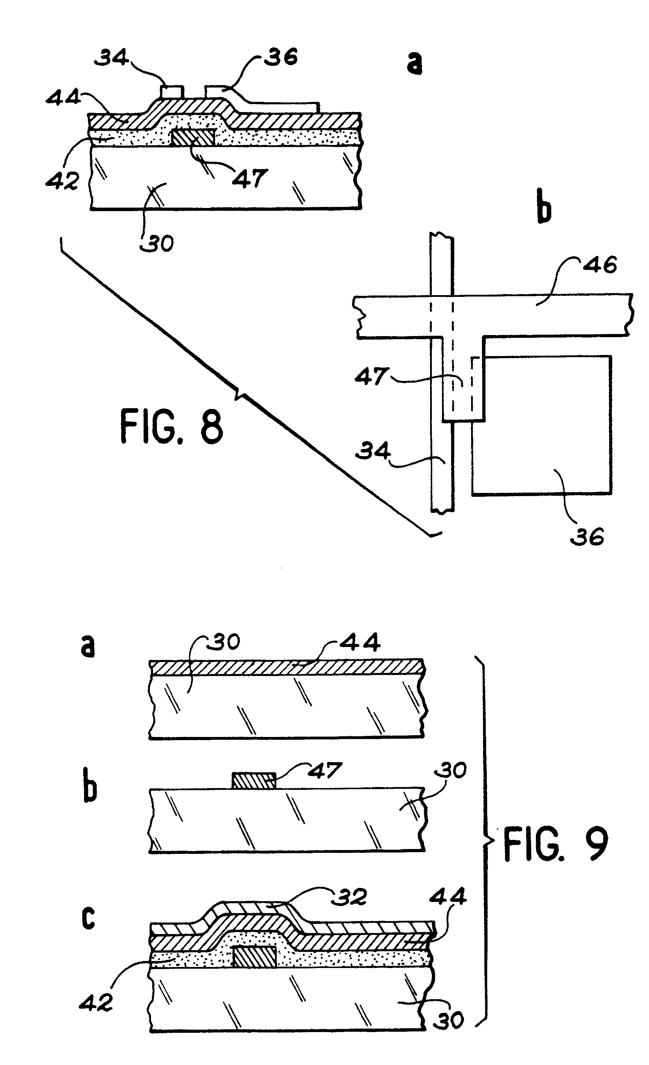

La figure 8 illustre une variante "inversée" de l'écran d'affichage de l'invention. Sur la partie a, qui est une coupe perpendiculaire aux colonnes, on voit que les grilles 47 des transistors sont situées sur la paroi 30 et que les colonnes 34 et les pavés 36 constituant les sources et les drains sont au-dessus de l'empilement carbure de silicium amorphe hydrogéné 44-isolant 42. Sur la partie b, on voit l'écran en vue de dessous et l'on note le segment 47 perpendiculaire à la ligne 46 et qui permet de constituer une grille pour le TCM, sous l'empilement semiconducteur-isolant.

Pour obtenir cette variante de l'écran, le procédé doit être légèrement modifié. Les opérations suivantes peuvent être effectuées, qui correspondent à la figure 9 :

- dépôt sur un substrat isolant 30 d'une couche 44 d'un matériau conducteur, en aluminium par exemple (a),
- photogravure de cette couche pour laisser subsister des lignes avec des segments 47 perpendiculaires aux lignes (b),
- dépôt d'une couche isolant 42 d'une couche de carbure de silicium amorphe hydrogéné 44, d'une couche d'un matériau conducteur transparent 32 (c),
- photogravure de cette dernière couche 32 pour former des colonnes 34 et des pavés 36 chevauchant partiellement les segments 47 perpendiculaires aux lignes.

On comprend, après cette description, que l'invention apporte trois sources de simplification qui conduisent à une réduction considérable du coût de l'écran d'affichage :

1) simplification des équipements : la gravure finale nécessaire au dégagement des lignes d'aluminium n'est pas critique et peut être effectuée dans des machines beaucoup plus rustiques que lorsqu'il s'agissait de graver l'ensemble de l'empilement constituant le niveau 2 ;

2) amélioration du rendement de fabrication : du fait de la disparition des tranches à nu, on supprime la cause principale de courts-circuits lignes-colonnes ;

3) simplification du procédé : la durée de fabrication se trouve nettement abrégée.

**Revendications**

1. Ecran d'affichage à matrice active comprenant une première paroi (10) portant un premier niveau constitué d'une matrice de pavés (22) et d'une famille de colonnes d'adressage (12) et un deuxième niveau comprenant une famille de lignes d'adressage (14), ces deux niveaux étant séparés par un empilement d'une couche de semiconducteur (40) et d'une couche isolante (42), cet écran comprenant encore une seconde paroi (24) recouverte d'une contre-électrode (26) et un cristal liquide compris entre les deux parois, cet écran étant caractérisé par le fait que, dans l'empilement séparant les deux niveaux, le semiconducteur (40) est en carbure de silicium amorphe hydrogéné, la couche de ce semiconducteur (40) ainsi que la couche d'isolant (42) recouvrant alors la totalité de la première paroi.

2. Ecran d'affichage selon la revendication 1, caractérisé par le fait que la concentration en carbone du carbure de silicium amorphe hydrogéné est de quelques pourcents.

3. Ecran d'affichage selon la revendication 1, caractérisé par le fait que l'épaisseur de la couche de carbure de silicium amorphe hydrogéné est voisine de 50 nm.

4. Ecran d'affichage selon la revendication 1, caractérisé par le fait que le premier niveau comprenant les colonnes d'adressage (12) et les pavés (22) est au contact avec la première paroi (10) et que le deuxième niveau avec les lignes d'adressage (14) est situé au-dessus de l'empilement carbure de silicium hydrogéné (40)-isolant (42).

5. Ecran d'affichage selon la revendication 1, caractérisé par le fait que le second niveau comprenant les lignes d'adressage (14) est au contact avec la première paroi (10), et que le premier niveau comprenant les colonnes d'adressage (12) et les pavés (22) est situé au-dessus de l'empilement isolant (42)-carbure de silicium hydrogéné (40).

6. Procédé de fabrication d'un écran d'affichage selon la revendication 1, consistant à déposer sur une première paroi (10), par seulement deux photogravures, un premier niveau comprenant une famille de colonnes d'adressage (12), une matrice de pavés (36), et un second niveau comprenant une famille de lignes d'adressage (14), et à constituer un empilement d'une couche de semiconducteur (40) et d'une couche isolante (42) séparant les deux niveaux, ce procédé étant caractérisé par le fait que le semiconducteur (40) est en carbure de silicium amorphe hydrogéné et que cette couche (40) ainsi que la couche isolante (42) sont maintenues sur la totalité de la paroi.

7. Procédé selon la revendication 6, caractérisé par le fait qu'il comprend les opérations suivantes :
   - dépôt sur un substrat isolant (30) d'une couche (32) d'un premier matériau conducteur transparent,
   - première photogravure appliquée à cette première couche pour constituer une matrice de pavés (36), chaque pavé étant relié à un segment de pavé (38), cette première photogravure laissant subsister en outre des colonnes (34) dudit premier matériau conducteur,
   - dépôt d'une couche (40) de carbure de silicium amorphe hydrogéné sur l'ensemble,
   - dépôt d'une couche isolante (42),
   - dépôt d'une couche (44) d'un second matériau conducteur,
   - seconde photogravure appliquée uniquement à ce second matériau conducteur, cette seconde photogravure laissant subsister des lignes (46) du second matériau conducteur, ces lignes passant au-dessus des segments de pavé (38), les zones de recouvrement d'une ligne (46) avec une colonne (34) et avec un segment de pavé (38) définissant la source et le drain d'un transistor en couches minces, la grille de ce transistor étant constituée par la partie de la ligne (46) qui est située entre le segment de pavé (38) et la colonne (34).

8. Procédé selon la revendication 6, caractérisé par le fait qu'il comprend les opérations suivantes :
   - dépôt sur un substrat isolant (30) d'une couche (44) d'un matériau conducteur,
   - photogravure de cette couche pour laisser subsister des lignes (46) avec des segments (47) perpendiculaires aux lignes,
   - dépôt d'une couche isolante (42),
   - dépôt d'une couche (40) de carbure de silicium amorphe hydrogéné,
   - dépôt d'une couche (32) d'un matériau conducteur transparent,
   - photogravure de cette dernière couche (32) pour former des colonnes (34) et des pavés (36) chevauchant partiellement les segments (47) perpendiculaires aux lignes.

## Claims

1. Active matrix delay screen comprising a first wall (10) carrying a first level constituted by a matrix of blocks (22) and a of addressing columns (12) and a second level comprising a group of addressing rows (14), said two levels being separated by a stack of a semiconductor layer (40) and an insulating layer (42), said screen also comprising a second wall (24) covered by a counterelectrode (26) and a liquid crystal between these two walls, characterized in that in the stack separating the two levels, the semiconductor (40) is of hydrogenated amorphous silicon carbide, the semiconductor layer (40) and the insulating layer (42) then covering the entire first wall.

2. Display screen according to claim 1, characterized in that the hydrogenated amorphous silicon carbide concentration is a few per cent.

3. Display screen according to claim 1, characterized in that the thickness of the hydrogenated amorphous silicon carbide layer is approximately 50 nm.

4. Display screen according to claim 1, characterized in that the first level comprising the addressing columns (12) and blocks (22) is in contact with the first wall (120 and in that the second level with the addressing rows (14) is positioned above the stack constituted by the hydrogenated silicon carbide (40) and the insulant (42).

5. Display screen according to claim 1, characterized in that the second level comprising the addressing rows (14) is in contact with the first wall (10) and in that the first level comprising the addressing columns (12) and the blocks (22) is positioned above the stack constituted by the insulant (42) and the hydrogenated silicon carbide (40).

6. Process for the production of a display screen according to claim 1, consisting of depositing on a first wall (10) by only two photogravure operations, a first level comprising a grasp of addressing columns (12), a matrix of blocks (36) and a second level comprising a grasp of addressing rows (14), and forming a stack of a semiconductor layer (40) and an insulating layer (42) separating the two levels, characterized in that the semiconductor (40) is of hydrogenated amorphous silicon carbide and the semiconductor layer (40) and the insulating layer (42) are located over the entire wall.

7. Process according to claim 6, characterized in that it comprises depositing a layer (32) of a first transparent conductive material on an insulating substrate (30), a first photogravure applied to said first layer to constitute a matrix of blocks (36), each block being connected to a block segment (38), said first photogravure leaving behind columns (34) of said first conductive material, deposition of a hydrogenated amorphous silicon carbide layer (40), deposition of an insulating layer (42), deposition of a layer (44) of a second conductive material, second photogravure applied solely to said second conductive material, said second photogravure leaving behind rows (46) of the second conductive material, these rows passing above the block segments (38), the overlap zones of a row (46) with a column (34) and with a block segment (38) defining the source and drain of a thin film transistor, the gate of said transistor being constituted by that part of the row (46) located between the block segment (38) and the column (34).

8. Process according to claim 6, characterized in that it comprises depositing on an insulating substrate (30) a layer (44) of a conductive material, photogravure of said layer to leave behind rows (46) with segments (47) perpendicular to the rows, deposition of an insulating layer (42), deposition of a hydrogenated amorphous silicon carbide layer (40), deposition of a layer (32) of transparent conductive material and photogravure of the last layer (32) to form columns (34) and blocks (36) partly overlapping the segments (47) perpendicular to the rows.

**Patentansprüche**

1. Anzeigetafel mit aktiver Matrix, die eine erste Seitenwand (10) aufweist, die ein erstes Niveau trägt, das aus einer Anzeigefleckenmatrix (22) und einer Adreßspaltenruppe (22) gebildet ist und ein zweites Niveau trägt, das eine Adreßzeilengruppe (14) aufweist, wobei die beiden Niveaus durch die Schichtung einer Halbleiterschicht (40) und einer Isolierschicht (42) getrennt sind, wobei die Anzeigetafel noch eine zweite Seitenwand (24) aufweist, die mit einer Gegenelektrode (26) bedeckt ist und einen Flüssigkristall zwischen den beiden Seitenwänden aufweist, wobei die Anzeigetafel dadurch gekennzeichnet ist, daß in der die beiden Niveaus trennenden Schichtung der Halbleiter (40) aus amorphem wasserstoffangereichertem Siliziumkarbid gebildet ist, wobei die Schicht dieses Halbleiters (40) sowie die Schicht des Isolators (42) so die Gesamtheit der ersten Seitenwand bedecken.

2. Anzeigetafel nach Anspruch 1, dadurch gekennzeichnet, daß die Konzentration an Kohlenstoff des amorphen wasserstoffangereicherten Siliziumkarbids einige Prozent beträgt.

3. Anzeigetafel nach Anspruch 1, dadurch gekennzeichnet, daß die Dicke der amorphen wasserstoffangereicherten Siliziimkarbid-Schicht in der Nähe von 50 nm liegt.

4. Anzeigetafel nach Anspruch 1, dadurch gekennzeichnet, daß das erste Niveau, das die Adreßspalten (12) und die Anzeigeflecken (22) aufweist, in Berührung steht mit der ersten Seitenwand (10) und daß das zweite Niveau mit den Adreßzeilen (14) oberhalb der Schichtung von wasserstoffangereichertem Siliziumkarbid (40) - Isolator (42) angeordnet ist.

5. Anzeigetafel nach Anspruch 1, dadurch gekennzeichnet, daß das zweite Niveau, das die Adreßzeilen (14) aufweist, in Kontakt mit der ersten Seitenwand (10) steht, und daß das erste Niveau, das die Adreßspalten (12) und die Adreßflecken (22) aufweist, oberhalb der Schichtung Isolator (42) - wasserstoffangereichertes Siliziumkarbid (40) angeordnet ist.

6. Verfahren zur Herstellung einer Anzeigetafel nach Anspruch 1, bestehend aus Ablegen auf einer ersten Seitenwand (10) durch nur zwei Photoätzungen, von einem ersten Niveau, das eine Adreßspaltengruppe (12), eine Anzeigenfleckenmatrix (36) aufweist, und von einem zweiten Niveau, das eine Adreßzeilengruppe (14) aufweist, und aus Bilden einer Schichtung einer Halbleiterschicht (40) und einer Isolatorschicht (42), die die beiden Niveaus trennt, wobei das Verfahren dadurch gekennzeichnet ist, daß der Halbleiter (40) aus wasserstoffangereichertem amorphem Siliziumkarbid gebildet ist und daß diese Schicht (40) sowie die Isolatorschicht (42) über die Gesamtheit der Seitenwand gehalten werden.

7. Verfahren nach Anspruch 6, dadurch gekennzeichnet, daß es die folgenden Verfahrensschritte aufweist:

   Ablage auf einem Isolatorsubstrat (30) einer Schicht (32) eines ersten durchsichtigen Leitermaterials,

   erste auf diese erste Schicht angewandte Phtoätzung, um eine Anzeigefleckenmatrix (36) zu bilden, wobei jeder Anzeigeflecken mit einem Anzeigenfleckensegment (38) verbunden ist, wobei diese erste Photoätzung darüber hinaus Spalten (34) des ersten Leitermaterials überläßt,

   Aufbringen einer Schicht (40) aus wasserstoffangereichertem amorphem Siliziumkarbid auf die Anordnung,

   Aufbringen einer Isolierschicht (42),

   Aufbringen einer Schicht (44) eines zweiten Leitermaterials,

   zweite Photoätzung aufgebracht nur auf das zweite Leitermaterial, wobei die zweite Photoätzung Zeilen (46) des zweiten Leitermaterials überläßt, wobei diese Zeilen, die oberhalb des Anzeigefleckensegments (38) vorbeigehen, die Überdeckungszonen einer Zeile (46) mit einer Spalte (34) und mit einem

7

Anzeigefleckensegment (38) Source und Drain eines Transistors in dünnen Schichten definieren, wobei das Gitter dieses Transistors gebildet wird durch den Bereich der Zeilen (46), die zwischen dem Anzeigenfleckensegment (38) und der Spalte (34) angeordnet sind.

8. Verfahren nach Anspruch 6, dadurch gekennzeichnet, daß es die folgeden Schritte aufweist:

Aufbringen auf einem Isoliersubstrat (30) einer Schicht (44) eines Leitermaterials,

Photoätzen dieser Schicht, um Zeilen (46) mit zu den Spalten senkrechten Segmenten (47) überzulassen,

Aufbringen einer Isolierschicht (42),

Aufbringen einer Schicht (40) von wasserstoffangereichertem amorphem Siliziumkarbid,

Aufbringen einer Schicht (32) eines zweiten durchsichtigen Leitermaterials,

Photoätzen dieser letzteren Schicht (32), um Spalten (34) und Anzeigeflecken (36) zu bilden, die teilweise die Segmente (47) senkrecht zu den Zeilen überlappen.

FIG. 1

FIG. 2

**FIG. 3**

**a**

**b**

**FIG. 4**

**FIG. 5**

**FIG. 7**

**FIG. 6**

**34**    **36**    **a**

**44**

**42**    **47**

**30**

**b**

**46**

**47**

**34**

**36**

# FIG. 8

**a**    **30**    **44**

**b**    **47**    **30**

# FIG. 9

**c**    **32**    **44**

**42**    **30**